# EUROPÄISCHE PATENTSCHRIFT

(11) **EP 2 581 426 B1**
(45) Veröffentlichungstag und Bekanntmachung des Hinweises auf die Patenterteilung: **28.12.2016**
(21) Anmeldenummer: 12187735.1
(22) Anmeldetag: 09.10.2012
(51) Int. Cl.: C09J 7/02, H05K 13/02

(54) **Selbstklebendes Spleißelement**
Self-adhesive splicing element
Élément d'épissurage autocollant

(30) Priorität: 12.10.2011 DE 202011106650 U
(43) Veröffentlichungstag der Anmeldung: 17.04.2013
(73) Patentinhaber: Max Steier GmbH & Co. KG, 25337 Elmshorn (DE)
(72) Erfinder: Achenbach, Frank, 25348 Glückstadt (DE); Klein-Boß, Peter, 25335 Elmshorn (DE)
(74) Vertreter: Hansen, Jochen

(56) Entgegenhaltungen:
- EP-A2- 1 198 166
- WO-A1-95/05989
- DE-B4- 19 983 273
- US-A- 2 994 362

## Beschreibung

Die Erfindung betrifft ein selbstklebendes Spleißelement zum Verbinden der Enden von Bauteilgurten, insbesondere zum Verbinden der Deckfolien von Bauteilgurten.

In Bauteilgurten werden, einem Magazin gleich, kleine, meist elektronische Bauteile (insbesondere auch in SMD-Technik) Bestückungsrobotern für Platinen und dergleichen zugeführt.

Die nur wenige Meter langen Bauteilgurte werden mit Fixierhilfen, wie sie beispielsweise in der DE 10 2009 060 774 A1 beschrieben sind, miteinander verbunden, so dass beim Zuführen der Bauelemente an einen Bestückautomaten oder-Roboter dieser, ohne am Ende eines Gurtes pausieren zu müssen, unterbrechungslos mit dem Entnehmen der Bauteile von mehreren aneinander anschließenden Gurten weiterarbeiten kann.

Dabei kommen häufig metallische Spleißstreifen zum Einsatz, die in entsprechenden Perforationen der Spleißgurte verankert werden. Neben den Spleißgurten selbst muss jedoch auch eine Deckfolie, die die Bauteile in einzelnen Kammern des Bauteilgurtes hält, miteinander verbunden werden. Dies wird üblicherweise durch selbstklebende Spleißelemente bewirkt, die beispielsweise oben auf die Gurte - neben der zum Verklemmen der metallischen Spleißstreifen angesetzten Backenzange - auf den Deckfolien beider miteinander zu verbindenden Enden aufgesetzt werden.

Es ist leicht ersichtlich, dass diese Klebestreifen nicht um den Bauteilgurt herumreichen dürfen, da sich die Deckfolien dann nicht mehr vom Bauteilgurt abheben ließen. Üblicherweise wird also ein schmales Stück Klebestreifen auf die schmalen Deckfolien aufgebracht.

Diese Arbeit, die von einem Operateur der einen Bestückungsautomaten mit einer Vielzahl derartiger Gurte betreut, mehrmals in einer Minute ausgeführt werden muss, ist ersichtlich handhabungstechnisch komplex und benötigt eine gehörige Portion Geschick. Da zudem Gurte verschiedener Art an einen Bestückungsautomaten zugeführt werden müssen, ist die Verwendung von Werkzeug, wie es beispielsweise in der EP 0 613 339 A1 beschrieben ist, unpraktisch. Der Operateur muss dort stets eine manuelle Applikation mehrer Abschnitte vornehmen.

In der Druckschrift DE 199 83 273 B4 wird ein Verbindungselement beschrieben, welches bei der Verbindung zweier Transportgurte sowohl den Gurt selbst, als auch die Abdeckfolie verbindet. Dabei wird beim Splicevorgang der gesamte Gurt umspannt. Charakteristisch für das hier beschriebene Verfahren ist die erforderliche Verwendung eines zusätzlichen Werkzeuges zur Ausrichtung des Splices an den zu verbindenden Gurten, da neben der Deckelfolie auch die Transportlochung überklebt wird.

Weiter ist in der Druckschrift US 2,994,362 A ein Verbindungselement beschrieben, welches zur Verbindung zweier Filmenden genutzt werden kann. Hierfür ist ein zusätzliches Montagewerkzeug (splicing assembly) erforderlich, um das Verbindungselement zu positionieren.

Weiter ist es aus dem Verkleben von Tonfilmen bekannt, dass man den Bereich der Tonspur nicht mit Klebefolie bedecken darf, so dass die DE 27 29 351 A1 vorschlägt, einen die Tonspur überdeckenden, mit Kleber versehenen Bereich einer Klebefolie für die beidseitige Verklebung der stumpf aufeinander stoßenden Enden abreißbar mit einer Lasche zu versehen.

Es ist zudem wünschenswert, dem Operateur eine schnelle, zielgenaue Anordnung der Spleißelemente ohne Anlageschablonen zu ermöglichen. Die Erfindung löst die Aufgabe mit den Merkmalen des Hauptanspruches. Die Unteransprüche geben vorteilhafte Ausführungsformen wieder.

Dabei kann eine Bedruckung auf dem Spleißelement durch farbige Ausgestaltung, farbige Markierungen oder auch geprägte Markierungen das schnelle lagerichtige Positionieren erleichtern. Insbesondere ist vorteilhaft, dass über den auf die Folien der Gurtenden zu positionierenden selbstklebenden Spleißstreifen ein hinausragender Handhabungsstreifen vorgesehen ist, der vorteilhaft mit Fingerbreite oder annähernd die Fingerbreite erreichender Breite entlang des Spleißstreifens zum Halten des Spleißstreifens zwischen zwei Fingern ausgebildet ist und zur schnellen Positionierung des Spleißelements dient. Das Spleißelement wird dann beim Verbinden der Deckfolie eines Bauteilgurtes mit dem vorderes Ende eines weiteres Gurtes beide Gurtenden einige Millimeter, bevorzugt jeweils 8 - 15mm bedecken. Es wird in der Regel nicht um den Gurt herum verklebt, da dies das Ablösen der Deckfolie in den Bestückungsrobotern zumindest erschweren würde.

Dabei ist der selbstklebende Streifen durch eine Perforation in Längsrichtung in zwei Teilstreifen vor-aufgeteilt, so dass er nach Entfernen eines Kleberschutzstreifens 12 schnell auf den Gurt aufgeklebt werden kann. Dieser Teil des selbstklebenden Streifens 14 ist zum größeren Teil mit dem Kleberschutzstreifen 12 haftverbunden, kann jedoch auch zu einem kleinen Teil, z.B. 0,1 - 0,5 mm noch auf einem die Perforation überlappenden Rand des Handhabungsstreifens verklebt sein.

Ein weiterer Teil 26 des selbstklebenden Streifens 14 ist mit dem Handhabungsstreifen 10 haftverbunden, und wird nach erfolgter Verbindung der Gurtfolien zusammen mit dem Handhabungsstreifen entlang der Perforation abgetrennt. Vorteilhaft ist insbesondere, dass sich der Kleberschutzstreifen 12 und der Handhabungsstreifen 10 quer zur Perforation überlappen. Diese Überlappung, die vorteilhafterweise die gesamte Länge des Spleißstreifens einnimmt, sorgt quasi automatisch beim In-die-Hand-Nehmen für ein Aufblättern des Kleberschutzstreifens gegenüber dem Handhabungsstreifen, so dass der Kleberschutzstreifen schnell entfernt werden kann, um den eigentlichen selbstklebenden Spleißstreifen auf die Gurtfolien aufzubringen.

In einer bevorzugten Ausführungsform haftet der Teilstreifen 26 auf einer nicht silikonisierten Fläche (also der Oberseite) des Handhabungsstreifens 10, und der Kleberschutzstreifen 12 ist umgekehrt mit wenigstens einer silikonisierten Seite versehen, die an dem selbstklebenden Teilstreifen 24 ablösbar haftet. Beim Ablösen bleibt der Kleberauftrag an dem Teilstreifen 24 überall dort erhalten, wo er direkt mit dem Kleberschutzstreifen haftete, während dies für den Teilstreifen 26, der auf dem nicht silikonisierten Handhabungsstreifen haftet, nicht gilt. Die Haftkraft auf der nicht silikonisierten Oberfläche ist deutlich stärker und sorgt für gute Haftung zwischen dem Handhabungsstreifen 10 und dem Teilstreifen 26.

Weiter ist es für die Anordnung und Dimensionierung der Überlappung günstig, wenn der Handhabungsstreifen 10 und der Kleberschutzstreifen 12 sich längs des Spleißelementes im Bereich der Perforation des selbstklebenden Streifens 14 um 0,5 bis 3 mm überlappen, insbesondere wenn der Handhabungsstreifen 10 die Perforation des selbstklebenden Streifens 14 überragt, so dass er beim Erstellen der Perforation auch noch durchstoßen wird. Der dann darunterliegende Kleberschutzstreifen 12 kann, wird aber meist nicht mehr durchstoßen werden.

Die bevorzugte Ausführungsform zeichnet sich durch eine Perforation aus, die auch den Handhabungsstreifen 10 durchdringt.

Weitere Merkmale und Vorteil der Erfindung ergeben sich aus nachfolgender Beschreibung eines bevorzugten Ausführungsbeispiels anhand der beigefügten Zeichnung.

Darin zeigen:
- Fig. 1: den erfinderischen Spleißstreifen während der Entfernung des Kleberschutzstreifens und
- Fig. 2: die nachfolgende Anbringung des im rechten Bereich schon in zwei Teilstreifen aufgeteilten Spleißstreifens mit seinem einen Teilstreifen auf die Deckfolie eines Bauteilgurtes, während der Handhabungsstreifen mit dem anderen Teilstreifen abgetrennt wird.

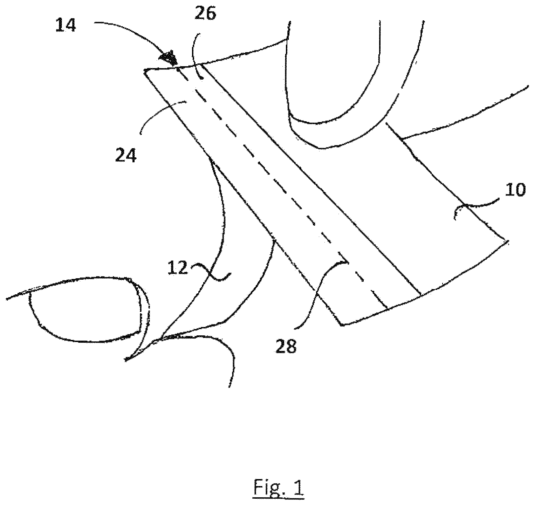

Der in der **Fig. 1** dargestellte Streifen weist einen Handhabungsstreifen 10 auf, der neben dem eigentlichen, auf den Deckfolien zu platzierenden Spleißstreifen seitlich an diesen anschließt.

Das erfindungsgemäße Spleißelement zum Verbinden einer Folie eines Bauteilgurtes mit derjenigen eines vorderen Endes eines weiteres Gurtes weist also zunächst einen selbstklebenden Streifen 14 auf, der entlang seiner Erstreckung zu einem nicht unwesentlichen Teil auf einem Handhabungsstreifen 10 klebbefestigt ist, wobei, wie in Fig. 1 erkennbar, der durch Bezugszeichen 14 bezeichnete selbstklebende Streifen durch eine Perforation 28 in Längsrichtung in zwei Teilstreifen 24, 26 voraufgeteilt ist. Der später zur Verklebung der Deckfolien genutzte Teilstreifen 24 kann ein Mehrfaches der Breite des anderen, auf dem Handhabungsstreifen 10 verbleibenden Teilstreifens 26 besitzen.

Dabei ist von diesem ggf. breiteren Teilstreifen 24 der größere Teil mit einem Kleberschutzstreifen 12 haftverbunden, während der weitere Teil 26 des selbstklebenden Streifens 14 an dem Handhabungsstreifen 10 haftverbunden ist, und der Kleberschutzstreifen 12 den Handhabungsstreifen 10 quer zur Perforation 28 überlappt. Diese Überlappung, bei der Kleberschutzstreifen 12 auf der Unterseite außen vor dem Handhabungsstreifen 10 zu liegen kommt, kann sich in einer anderen Ausführungsform auch erst bei einem ersten Biegen einstellen.

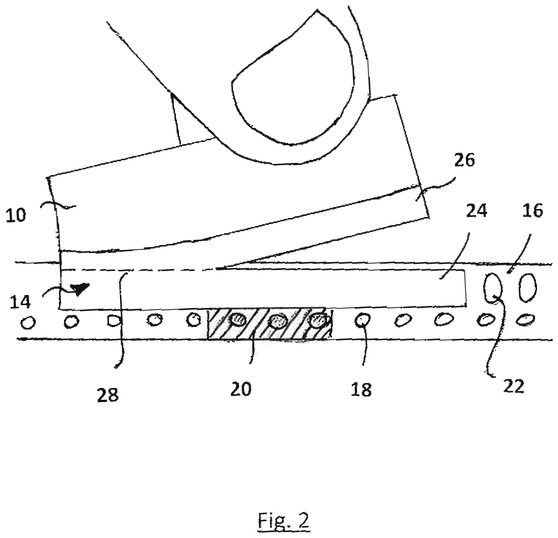

Bevorzugt wird, dass der Kleberschutzstreifen 12 den Handhabungsstreifen 10 bereits von Beginn an außen überlappt, und so von den in Fig. 1 links dargestellten Fingern leicht gegriffen werden kann. Die andere Hand des Benutzers hält, wie mit den rechts dargestellten zwei Fingern dargestellt, beim Ablösen des Kleberschutzstreifen 12 den Handhabungsstreifen 10. Nach Ablösung wird die Unterseite des selbstklebenden Streifens, in dem Teilbereich des Teilstreifens 24 auf einer Deckfolie aufgebracht, wie dies in Fig. 2 dargestellt ist.

Der skizzierte Bauteilgurt 16 mit seinen durch eine nicht dargestellte Folie bedeckten Bauteilen 22 weist üblicherweise Löcher 18 auf, die neben dem Gurtvortrieb zur Anbringung eines Verbinders 20 dienen (der in der Fig. 2 als von der Rückseite in den Löchern 18 vercrimpt dargestellt ist). Auf die die Vorderseite bedeckenden Enden einer Deckfolie wird der Teilstreifen 24 aufgeklebt, und im Anschluss daran dann, wie es Fig. 2 zeigt, der Handhabungsstreifen mit dem Teilstreifen 26 abgetrennt, ohne wieder den Teilstreifen 24 abzuheben. Die Qualität der Perforation zwischen den Teilstreifen 24 und 26 muss daher gleichbleibend gut sein. Es wird vorgeschlagen, eine Perforation zu verwenden, die nur Mikrostege belässt, die zudem erst 1-3 mm entfernt vom Ende des Streifens beginnen, so dass dort ein längerer Schlitz als in der Mitte der Perforation ausgebildet ist.

Die erfindungsgemäß vorgeschlagene Überlappung, die vorteilhafterweise wenigstens an den Enden, der Einfachheit halber aber entlang der ganzen Erstreckung von dem Kleberschutzstreifen 12 und/oder dem Handhabungsstreifen 10 vorgesehen wird, bewirkt, das bei einem leichten Biegen des gesamten Spleißelements der nicht klebverbundene, überlappende Teil absteht. Auf diese Weise wird dann mit einfachem Handgriff die in Fig. 1 dargestellte Ablösung des Kleberschutzstreifens 12 von Handhabungsstreifen 10 und selbstklebendem Streifen ermöglicht, ohne zunächst die Perforation zu belasten.

Weiter wird vorgeschlagen, dass der Teilstreifen 26 auf einer nicht-silikonisierten Fläche des Handhabungsstreifens 10 haftet, und der Kleberschutzstreifen 12 mit wenigstens einer silikonisierten Seite versehen ist, die an dem selbstklebenden Teilstreifen 24 ablösbar haftet. Auch andere die Ablösbarkeit erleichternde Maßnahmen, wie Riffelfolien oder die Verwendung anderer Chemikalien, die die Ablösbarkeit erleichtern, ist möglich. Insbesondere ist die Verwendung von PE denkbar.

Der Handhabungsstreifen 10 und der Kleberschutzstreifen 12 überlappen sich längs des Spleißelementes an der Unterseite im Bereich der Perforation des selbstklebenden Streifens 14. In Fig. 1 ist nur die Oberseite des selbstklebenden Streifens 14 erkennbar, und in Fig. 2 ist der Kleberschutzstreifen 12 schon entfernt.

Ebenfalls in Fig. 2 nicht dargestellt ist eine Variante, bei der Handhabungsstreifen 10 die Perforation des selbstklebenden Streifens 14 mit Überlappung überragt. Vorteilhaft, aber nicht zwingend ist, dass der Handhabungsstreifen 10 unter dem Kleberschutzstreifen 12 an dem selbstklebenden Streifen 14 haftet, so dass einfach die Perforation 28 auch den Handhabungsstreifen 10 durchdringt. Dies macht unter anderem die Erstellung der Perforation 28 im selbstklebenden Streifen einfacher reproduzierbar.

Weiter wird eine bevorzugte Ausbildung des Spleißelements vorgeschlagen, bei der der Handhabungsstreifen 10 über z. B. eine Abreisskante mit einem nächsten Handhabungsstreifen als Rollenware konfektioniert ist.

Der Handhabungsstreifen 10 wird insbesondere bestehend als einseitig an der Unterseite silikonisiertes Papier oder Folie vorgeschlagen. Schließlich wird vorgeschlagen, den Handhabungsstreifen 10 mechanisch fester, z. B. mit einer größeren Dicke und/oder Steifigkeit als den selbstklebenden Spleißstreifen 14 auszubilden.

### Bezugszeichenliste

- 10: Handhabungsstreifen
- 12: Kleberschutzstreifen
- 14: selbstklebender Streifen
- 16: Bauteilgurt
- 18: Loch

- 20: Verbinder
- 22: Bauteil
- 24: Teilstreifen
- 26: Teilstreifen
- 28: Perforation

## Patentansprüche

1. Spleißelement zum Verbinden einer Folie eines Bauteilgurtes mit derjenigen eines vorderen Endes eines weiteren Gurtes mit einem selbstklebenden Streifen (14)an einem Handhabungsstreifen (10), wobei der selbstklebende Streifen (14) die beiden Gurtenden teilweise bedeckt,und der selbstklebende Streifen (14) durch eine Perforation in Längsrichtung in zwei Teilstreifen (24, 26) vor-aufgeteilt ist, wobei ein Teil des einen Teilstreifens (24) des selbstklebenden Streifens (14) mit einem Kleberschutzstreifen (12) haftverbunden ist, der weitere Teil (26) des selbstklebenden Streifens (14) an dem Handhabungsstreifen (10) haftverbunden ist,
**dadurch gekennzeichnet, dass**
der Kleberschutzstreifen (12) mit wenigstens einer silikonisierten Seite oder mit anderen die Ablösbarkeit erleichternden Maßnahmen versehen ist, die an dem selbstklebenden Teilstreifen (24) ablösbar haftet
und
der weitere Teil des selbstklebenden Streifens (26) auf einer nichtsilikonisierten Fläche des Handhabungsstreifens (10) haftet,
und
der Kleberschutzstreifen (12) und der Handhabungsstreifen (10) einander quer zur Perforation derart überlappen, dass bei einem leichten Biegen des gesamten Spleißelementes der nicht kleberverbundene, überlappende Teil absteht und mit einem einfachen Handgriff die Ablösung des Kleberschutzstreifens (12) vom Handhabungsstreifen (10) und dem selbstklebendem Streifen (14) ermöglicht wird.

2. Spleißelement nach Anspruch 1, **dadurch gekennzeichnet, dass** der Handhabungsstreifen (10) und der Kleberschutzstreifen (12) sich längs des Spleißelementes im Bereich der Perforation des selbstklebenden Streifens (14) überlappen.

3. Spleißelement nach Anspruch 1 oder 2, **dadurch gekennzeichnet, dass** der Handhabungsstreifen (10) die Perforation des selbstklebenden Streifens (14) mit Überlappung überragt.

4. Spleißelement nach einem der vorangehenden Ansprüche, **dadurch gekennzeichnet, dass** der Handhabungsstreifen (10) unter dem Kleberschutzstreifen (12) an dem selbstklebenden Streifen (14) haftet.

5. Spleißelement nach Anspruch 3 oder 3 und 4, **dadurch gekennzeichnet, dass** die Perforation (28) auch den Handhabungsstreifen (10) durchdringt.

6. Spleißelement nach einem der vorangehenden Ansprüche, **dadurch gekennzeichnet, dass** der Handhabungsstreifen (10) mit einer größeren Steifigkeit als der selbstklebende Spleißstreifen (14) ausgebildet ist.

## Claims

1. Splicing element for connecting a film of a component belt to that of a front end of a further belt with a self-adhesive strip (14) on a handling strip (10), the self-adhesive strip (14) at least partly covering the two belt ends, and the self-adhesive strip (14) being pre-divided into two partial strips (24, 26) by a perforation in the longitudinal direction, one part of the one partial strip (24) of the self-adhesive strip (14) being adhesively bonded to an adhesive protective strip (12), the other part (26) of the self-adhesive strip (14) being adhesively bonded to the handling strip (10), **characterised in that**
the adhesive protective strip (12) is provided with at least one siliconized side or with other measures facilitating the releasability, which releasably adheres to the self-adhesive partial strip (24),
and
the other part of the self-adhesive strip (26) adheres to a non-siliconized surface of the handling strip (10),
and
the adhesive protective strip (12) and the handling strip (10) overlap each other transversely to the perforation in such a way that on a slight bending of the entire splicing element the overlapping part not adhesively bonded protrudes and with a simple manipulation the release of the adhesive protective strip (12) from the handling strip (10) and the self-adhesive strip (14) is made possible.

2. Splicing element according to Claim 1, **characterised in that** the handling strip (10) and the adhesive protective strip (12) overlap each other along the splicing element in the region of the perforation of the self-adhesive strip (14).

3. Splicing element according to Claim 1 or 2, **characterised in that** the handling strip (10) projects with overlap beyond the perforation of the self-adhesive strip (14).

4. Splicing element according to one of the preceding claims, **characterised in that** the handling strip (10) adheres to the self-adhesive strip (14) under the adhesive protective strip (12).

5. Splicing element according to Claim 3 or 3 and 4, **characterised in that** the perforation (28) also penetrates the handling strip (10).

6. Splicing element according to one of the preceding claims, **characterised in that** the handling strip (10) is formed with a greater rigidity than the self-adhesive splicing strip (14).

## Revendications

1. Élément de raccordement bout à bout destiné à relier un film d'une ceinture de composant à celui d'une extrémité avant d'une autre ceinture au moyen d'une bande autocollante (14) placée sur une bande de manipulation (10), la bande autocollante (14) recouvrant en partie les deux extrémités de ceinture, et la bande autocollante (14) étant préalablement divisée en deux sous-bandes (24, 26) par une perforation dans la direction longitudinale, une partie d'une des sous-bandes (24) de la bande autocollante (14) étant reliée par adhérence à une bande de protection de la colle (12), l'autre partie (26) de la bande autocollante (14) étant reliée par adhérence à la bande de manipulation (10), **caractérisé en ce que**
la bande de protection de la colle (12) est pourvue d'au moins une face siliconée ou d'autres mesures facilitant l'aptitude au détachement, qui adhère(nt) de manière détachable à la sous-bande autocollante (24),
et
l'autre partie de la bande autocollante (26) adhère à une surface non siliconée de la bande de manipulation (10),
et
la bande de protection de la colle (12) et la bande de manipulation (10) se chevauchent mutuellement transversalement à la perforation de telle sorte que dans le cas d'une légère flexion de l'ensemble de l'élément de raccordement bout à bout, la partie chevauchante non reliée par collage saille et un simple mouvement de la main permet de détacher la bande de protection de la colle (12) de la bande de manipulation (10) et de la bande autocollante (14).

2. Élément de raccordement bout à bout selon la revendication 1, **caractérisé en ce que** la bande de manipulation (10) et la bande de protection de la colle (12) se chevauchent le long de l'élément de raccordement bout à bout dans la zone de la perforation de la bande autocollante (14).

3. Élément de jonction selon la revendication 1 ou 2, **caractérisé en ce que** la bande de manipulation (10) dépasse par chevauchement de la perforation de la bande autocollante (14).

4. Élément de raccordement bout à bout selon l'une des revendications précédentes, **caractérisé en ce que** la bande de manipulation (10), sous la bande de protection de la colle (12), adhère à la bande autocollante (14).

5. Élément de raccordement bout à bout selon la revendication 3 ou 3 et 4, **caractérisé en ce que** la perforation (28) traverse également la bande de manipulation (10).

6. Élément de raccordement bout à bout selon l'une des revendications précédentes, **caractérisé en ce que** la bande de manipulation (10) présente une rigidité supérieure à celle de la bande de raccordement bout à bout autocollante (14).
